Europäisches Patentamt

European Patent Office

Office européen des brevets

(11) Veröffentlichungsnummer: **0 260 539 B1**

# EUROPÄISCHE PATENTSCHRIFT

(45) Veröffentlichungstag der Patentschrift: **02.01.92**

(21) Anmeldenummer: **87112869.0**

(22) Anmeldetag: **03.09.87**

(51) Int. Cl.⁵: **B05B 5/08**, B05B 13/02, B05B 15/04

(54) **Vorrichtung zur Sprühbeschichtung von Werkstücken.**

(30) Priorität: **13.09.86 DE 3631270**

(43) Veröffentlichungstag der Anmeldung:
**23.03.88 Patentblatt 88/12**

(45) Bekanntmachung des Hinweises auf die
Patenterteilung:
**02.01.92 Patentblatt 92/01**

(84) Benannte Vertragsstaaten:
**AT BE CH ES FR GB IT LI LU NL SE**

(56) Entgegenhaltungen:
DE-A- 2 446 767
FR-A- 2 237 684
US-A- 1 627 096

PATENT ABSTRACTS OF JAPAN, Band 10,
Nr. 182 (C-356)[2238], 25. Juni 1986; & JP-
A-61 28 475 (TOKICO LTD) 08-02-1986

PATENT ABSTRACTS OF JAPAN, Band 10,
Nr. 194 (C-358)[2250], 8. Juli 1986; & JP-A-61
38 653 (MATSUO SANGYO K.K.) 24-02-1986

(73) Patentinhaber: **Böllhoff Verfahrenstechnik
GmbH & Co. KG
Gütersloher Strasse 259
W-4800 Bielefeld 14(DE)**

(72) Erfinder: **Heine, Werner
Kastanienstrasse 77
W-5057 Winnenden 3(DE)**
Erfinder: **Kurz, Helmut
Forststrasse 26
W-5057 Winnenden(DE)**

(74) Vertreter: **Knoblauch, Ulrich, Dr.-Ing.
Kühhornshofweg 10
W-6000 Frankfurt am Main 1(DE)**

# Beschreibung

Die Erfindung bezieht sich auf eine Vorrichtung zur Sprühbeschichtung von Werkstücken mit einem horizontal unter einer Sprühvorrichtung verlaufenden Transportweg für die Werkstücke und einer unter den Werkstücken angeordneten, einmal verwendbaren Abdeckbahn zur Aufnahme von nicht auf die Werkstücke auftreffendem Beschichtungsmaterial, insbesondere zur elektrostatischen Beschichtung mittels eines Rotationszerstäubers.

Es ist bekannt, beispielsweise aus WO 86/01745 Photolacke und Lötstoplacke auf kupferkaschierte Leiterplatten mittels eines Rotationszerstäubers und eines elektrostatischen Feldes aufzutragen. Hierbei werden die Leiterplatten auf einem aus Papier bestehenden Förderband horizontal unter dem Rotationszerstäuber hinweg bewegt. Das Papier dient gleichzeitig als Abdeckbahn, die eine Verschmutzung des Bodens durch das Beschichtungsmaterial verhindert. Unter dem Papier befindet sich eine geerdete Elektrode.

Die Papierbahn kann nur einmal verwendet werden. Dies führt zu erheblichen Kosten, weil der Papierverbrauch mit der Fördergeschwindigkeit der Werkstücke proportional ist.

Der Erfindung liegt die Aufgabe zugrunde, eine Vorrichtung der eingangs beschriebenen Art anzugeben bei der die gleichen Beschichtungseffekte mit geringeren Kosten erzielt werden können.

Diese Aufgabe wird erfindungsgemäß dadurch gelöst, daß zum Transport der Werkstücke ein endloses durchbrochenes Förderband vorgesehen ist und daß die Abdeckbahn unter den Förderband verläuft und eine geringere Durchschnittsgeschwindigkeit als das Förderband hat.

Bei dieser Konstruktion ist die Transportfunktion von der Abdeckfunktion getrennt. Die Abdeckbahn kann sehr viel langsamer bewegt werden als die Werkstücke. Dies ergibt erhebliche Kosteneinsparungen. Hierbei ist ferner zu berücksichtigen, daß das Material der Abdeckbahn besser als bisher ausgenutzt werden kann, weil die Zwischenräume zwischen aufeinanderfolgenden Werkstücken sich relativ zur Abdeckbahn bewegen. Ein weiterer Vorteil besteht darin, daß eine Beschichtung umlaufender Kanten, z. B. Schnittkanten bei Leiterplatten, erfolgen kann, ohne daß ein zusammenhängender Film zwischen Werkstück und Abdeckbahn entsteht und daher bei Abnahme des Werkstücks vom Förderband diese Kantenbeschichtung durch Anheften an der Abdeckbahn zerstört wird.

Das Förderband besteht vorzugsweise aus mehreren parallelen Drähten, Schnüren oder Fäden. Diese Materialien bieten dem Beschichtungsmaterial nur wenig Angriffsfläche und werden daher an den freiliegenden Stellen nur unwesentlich verschmutzt. Auf der anderen Seite können diese Materialien eine wesentlich größere Zugfestigkeit als eine aus Papier bestehende Abdeckbahn haben, so daß kaum ein Durchhang des Förderbandes auftritt und bei Werkstücken unterschiedlichen Gewichts die gleichen Verhältnisse gegeben sind.

Insbesondere kann das Förderband aus isolierendem Kunststoff bestehen. Dieses Material ist leicht und trotzdem zugfest.

Günstig ist es, wenn das Förderband beim Rücklauf eine Reinigungsvorrichtung durchläuft. Die Werkstücke werden daher immer auf einem sauberen Förderband durch die Beschichtungszone transportiert.

Da die Abdeckbahn keiner Gewichtsbelastung durch die Werkstücke mehr ausgesetzt ist, kann für sie verhältnismäßig leichtes Material verwendet werden. Insbesondere kann die Abdeckbahn aus leichtem Papier mit einem Gewicht von höchstens 40 $g/m^2$ bestehen. Ein Papier-Förderband muß mindestens 50 $g/m^2$ haben. Hierdurch werden nochmals Kosten eingespart.

Die Trennung der beiden Funktionen erlaubt es auch, bei Stoß an Stoß zugeführten Werkstücken oder bei Endloswerkstücken die Abdeckbahn nur an den Rändern des Förderbandes vorzusehen, also wiederum Kosten zu sparen.

Die Abdeckbahn kann kontinuierlich langsamer als das Förderband angetrieben werden. Es kann aber auch mit Vorteil ein in Intervallen arbeitender Antrieb für die Abdeckbahn vorgesehen sein.

Es ist sogar möglich, den Antrieb für die Abdeckbahn von deren Verschmutzungsgrad abhängig zu machen. Hierfür gibt es verschiedene Möglichkeiten, beispielsweise die Abhängigkeit von der Messung des Gewichts der Abdeckbahn pro Flächeneinheit oder ihrer Strahlungsdurchlässigkeit. Man kann auch die Menge des der Sprühvorrichtung zugeführten Beschichtungsmaterials messen und in Abhängigkeit hiervon den Antrieb regeln.

Bei einer elektrostatischen Beschichtung kann das Förderband aus elektrisch leitendem Material bestehen und geerdet sein. Auf diese Weise sind auch die Werkstücke geerdet.

Da hierbei aber ein vermehrter Teil des Beschichtungsmaterials sich am Förderband absetzt, ist es empfehlenswert, bei einer elektrostatischen Beschichtung zur berührungslosen Entladung der Werkstücke eine mit Luftionisation arbeitende Neutralisierungsvorrichtung unterhalb der Abdeckbahn anzuordnen. Durch die Ionisierung wird die elektrische Leitfähigkeit der Luft erhöht, wodurch die durch die ionisierten Beschichtungströpfchen aufgeladenen Werkstücke bis auf eine so geringe Restladung entladen werden, daß keine Gefahr einer Funkenentladung besteht. Bei einer Wechselspannungs-Ionisierung erfolgt auch eine kapazitive Ladungsbildung an der Werkstück-Oberfläche. Umgekehrt ist diese Neutralisierungsvorrichtung durch die Abdeckbahn gut gegenüber dem Beschichtungsmaterial geschützt.

Besonders günstig ist es, daß die Abdeckbahn für Luft, nicht aber für Beschichtungsmaterial durchlässig ist. Die Luftionen gelangen dann ohne Schwierigkeiten zum Werkstück, während das Beschichtungsmaterial sicher festgehalten wird. Eine Möglichkeit besteht darin, daß die Abdeckbahn fein gelocht ist. Eine andere Möglichkeit wird darin gesehen, daß die Abdeckbahn aus einem Vlies besteht, das nicht nur eine gewisse Luftdurchlässigkeit, sondern auch eine gute Aufnahmefähigkeit für das Beschichtungsmaterial hat.

Insbesondere kann die Neutralisierungsvorrichtung so dicht unterhalb der Abdeckbahn angeordnet sein, daß diese im Ionisierungsbereich der Neutralisierungsvorrichtung liegt. Das bedeutet, daß die Neutralisierungsvorrichtung die Abdeckbahn berührt oder ihr sehr nahe ist. Auf diese Weise gelangen die Luftionen noch besser an die Werkstücke.

Vorzugsweise besitzt die Neutralisierungsvorrichtung eine Anzahl von zur Abdeckbahn hin gerichteten Ionisierungs-Spitzen. Der Weg der Ionen zum Werkstück ist daher kurz.

Hierbei empfiehlt es sich, daß die Ionisierungs-Spitzen in mehreren Reihen angeordnet sind, die quer zur Förderrichtung nebeneinander angeordnet sind, wobei die Wirkungsbreite durch Zu- bzw. Abschalten von einzelnen Reihen einstellbar ist. Auf diese Weise kann eine Anpassung der Neutralisierungsvorrichtung an die Werkstückbreite vorgenommen werden.

Günstig ist es auch, daß der vertikale Abstand der Abdeckbahn vom Förderband gerade so groß ist, daß bei beladenem Förderband noch keine Berührung stattfindet. Die Nähe zur Abdeckbahn ermöglicht eine Nähe zur Neutralisierungsvorrichtung und daher eine besonders gute Entladung.

Bei einer bevorzugten Ausführungsform bildet die Abdeckbahn den Boden einer Kabine, in der die Sprühvorrichtung angeordnet ist. Die Kabine kann daher im wesentlichen abgeschlossen sein, so daß der Beschichtungsvorgang nicht durch unerwünschte Luftströmungen beeinträchtigt wird.

Vorzugsweise ist die Kabine mit Unterdruck betreibbar. Die Luftionen, die von der Neutralisierungsvorrichtung unterhalb der Abdeckbahn erzeugt werden, erhalten dann eine zusätzliche Antriebskraft, um zum Werkstück zu wandern.

Die Erfindung wird nachstehend anhand eines in der Zeichnung dargestellten, bevorzugten Ausführungsbeispiels näher erläutert. Es zeigen:

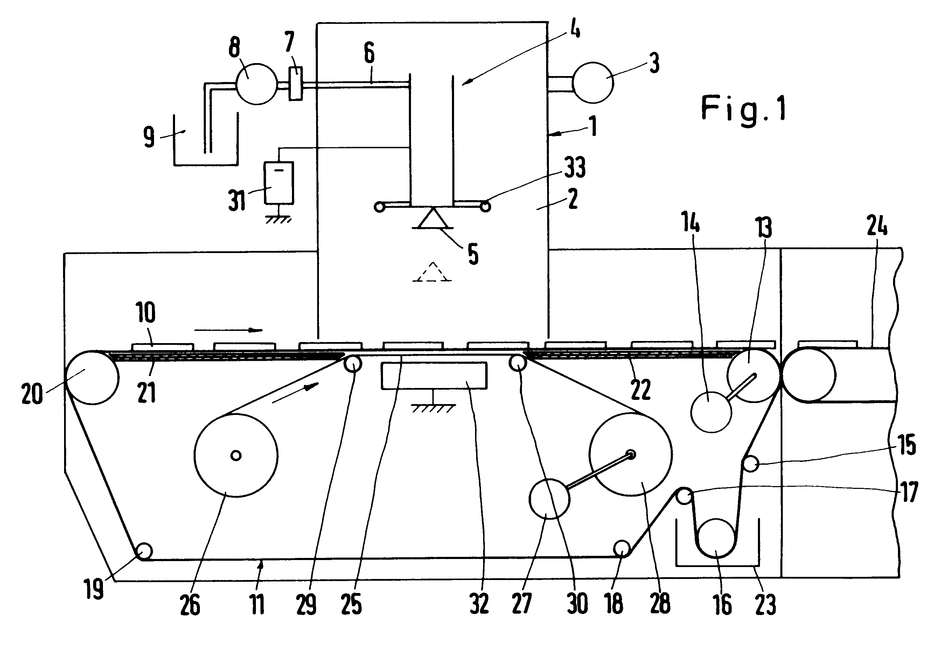

Fig. 1 eine schematische Seitenansicht einer erfindungsgemäßen Vorrichtung,

Fig. 2 eine Draufsicht auf Abdeckbahn, Förderband und Werkstück,

Fig. 3 einen Längsschnitt durch die Anordnung der Fig. 2,

Fig. 4 eine Draufsicht auf die Neutralisierungsvorrichtung und

Fig. 5 eine Draufsicht auf eine abgewandelte Ausführungsform.

Eine Beschichtungskabine 1, deren Innenraum 2 mittels einer Saugpumpe 3 unter Unterdruck gesetzt werden kann, enthält eine Sprühvorrichtung 4. Diese besitzt einen Rotationszerstäuber 5, der in der Höhe verstellbar ist, wie es gestrichelt veranschaulicht ist, und quer zur Transportrichtung oszilieren kann. Ihm wird Beschichtungsmaterial über eine Leitung 6, die eine Mengenmeßvorrichtung 7 enthält, von einer Pumpe 8 aus einem Behälter 9 zugeführt. Bei einem Mehrkomponenten-Material kann die Zufuhr von mehreren Behältern her erfolgen. Bei elektrostatischer Beschichtung von gut leitfähigem Material können Behälter und Leitung aus Isoliermaterial bestehen, so daß das Material Hochspannungspotential haben kann.

Werkstücke 10 werden auf einem Förderband 11 horizontal unter der Sprühvorrichtung 4 hinwegbewegt. Insbesondere handelt es sich um kupferkaschierte Leiterplatten, die mit einem Photolack oder Lötstoplack beschichtet werden sollen. Es kommen aber auch andere plattenförmige oder beliebig geformte Werkstücke in Betracht. Das Förderband besteht aus mehreren parallel nebeneinander verlaufenden Schnüren 12, insbesondere mit Kreisquerschnitt, aus Kunststoff, beispielsweise Polyamid, die von einer Antriebswalze 13 mittels eines Motors 14 angetrieben und über mehrere Walzen 15 bis 20 umgelenkt und geleitet werden. Im oberen Bereich können die Schnüre auf Stützplatten 21 und 22 aufliegen. Im Rücklauf ist eine Reinigungsvorrichtung 23 vorgesehen, welche an den Schnüren haftendes Beschichtungsmaterial entfernt. Die Reinigung kann chemisch, mechanisch oder auf eine beliebige andere Weise erfolgen. Ihr kann eine Trocknung folgen. Die Werkstücke werden vom Förderband 11 auf ein weiteres Förderband 24 übertragen, das die Werkstücke durch eine Trockenzone und andere Arbeitsbereiche führt.

Der Kabinenboden besteht aus einer Abdeckbahn 25, die von einer Vorratsrolle 26 abgewickelt und auf eine durch einen Antrieb 27 gedrehte Walze 28 aufgewickelt wird.

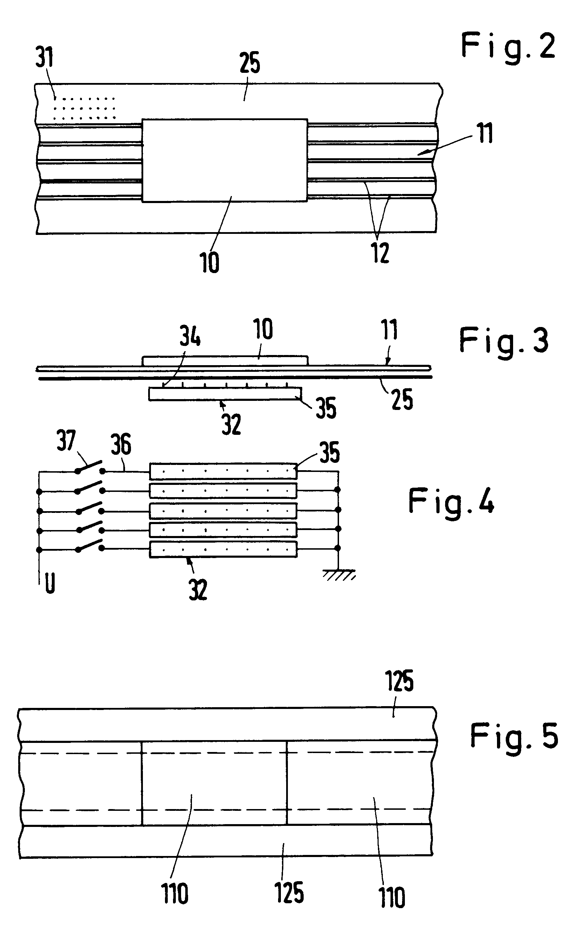

Die Abdeckbahn läuft hierbei über zwei Leitwalzen 29 und 30. Die Abdeckbahn 25 erstreckt sich über die gesamte Bodenöffnung der Kabine 1. Sie besteht aus leichtem Papier von beispielsweise 30 g/m². Die Abdeckbahn weist feine Perforationen 31 auf, wie es in Fig. 2 angedeutet ist. Diese erlauben einen Luftdurchtritt, nicht aber einen Durchtritt des Beschichtungsmaterials. Auch ein Faservlies kann verwendet werden, weil es ähnliche Eigenschaften hat und überdies Beschichtungmaterial besonders gut aufzusaugen vermag. Der Antrieb 27 verleiht der Abdeckbahn 25 eine erheblich geringere Durchschnittsgeschwindigkeit als die Geschwindigkeit des Förderbandes 11, das vom Motor 14 her angetrieben wird. Die Abdeckbahn 25 nimmt dasjenige Beschichtungsmaterial auf, das beim Durchlauf der Werkstücke 10 nicht auf diese trifft. Es wird daher eine Verschmutzung des darunter befindlichen Anlagenteils und der dort angeordneten Geräte verhindert. Der Antrieb 27 kann kontinuierlich oder intervallmäßig betrieben werden. Er kann von der Mengenmeßvorrichtung 7 oder einer anderen den Verschmutzungsgrad kennzeichnenden Größe gesteuert werden. Da die Werkstücke 10 nicht auf der Abdeckbahn 25 aufliegen, können sie auch nicht durch Flusen o.dgl. des Papiers verunreinigt werden.

Die Beschichtung wird elektrostatisch unterstützt. Zu diesem Zweck ist ein Hochspannugserzeuger 31 vorgesehen, dessen Spannung führende Ausgangsklemme mit dem Kopf des Rotationszerstäubers 5 in Verbindung steht. Unterhalb der Abdeckbahn 25 befindet sich in der Beschichtungszone eine Neutralisierungsvorrichtung 32, welche die Werkstücke 10 berührungslos bis auf eine ungefährliche Restladung zu entladen vermag. Die Sprühteilchen des Beschichtungsmaterials folgen den Feldlinien und erlauben eine gleichmäßige Beschichtung der Werkstücke 10. Eine Zusatzelektrode 33 dient der Formung des Feldes derart, daß sich ein etwa elliptisches Sprühbild ergibt. Die Neutralisierungsvorrichtung 32 weist eine Reihe von Spitzen 34 auf, an denen eine Luftionisation stattfindet. Dies kann beispielsweise dadurch geschehen, daß den Spitzen 34 isolierte Leiter benachbart sind, die mit einer hochgespannten Wechselspannung versorgt werden, wie dies in DE-OS 24 46 767 näher erläutert ist. Hierbei ragen die Spitzen 34 aus einer Längsnut eines Stabes 35, der über ein Hochspannungskabel 36 mit einer Wechselspannung U beschickt wird. Die ionisierten Luftmoleküle vermögen durch die Abdeckbahn 25 zu treten und können dann die Werkstücke neutralisieren.

Der Abstand der Spitzen 34 zur Abdeckbahn 25 ist gering; selbst eine Berührung ist zulässig. Der Abstand zwischen dem Förderband 11 und der Abdeckbahn 25 ist ebenfalls gering. Es ist lediglich anzustreben, daß keine unmittelbare Berührung zwischen Förderband und Abdeckbahn erfolgt. Infolgedessen sind die Werkstücke 10 dem Ionisationsbereich eng benachbart, was eine hohe Wirksamkeit gewährleistet.

Es sind mehrere Stäbe 35 quer zur Transportrichtung nebeneinander angeordnet. Der Anschluß des Hochspannungskabels 36 an die Wechselstromspannung U erfolgt über je einen Schalter 37. Man kann daher die wirksame Breite der Neutralisierungsvorrichtung 32 der Werkstückbreite anpassen.

Die elektrostatische Beschichtung erlaubt es, bei größerem Abstand von beispielsweise 20 mm zwischen Werkstück 10 und Abdeckbahn 25 die umlaufenden Kanten im Umgriff zu beschichten. Bei einem kleineren Abstand von beispielsweise 2 mm dagegen erzielt man, was häufig erwünscht ist, eine vollständige Beschichtung der umlaufenden Kante ohne Beschichtung des Randes der Werkstückunterseite.

Bei der Ausführungsform der Fig. 5 sind Werkstücke 110 Stoß an Stoß angeordnet, so daß zwischen ihnen kein Beschichtungsmaterial hindurchtreten kann. Hier genügt es, die Abdeckbahn aus zwei lediglich am Rand der Werkstücke verlaufenden Streifen 125 bestehen zu lassen.

Statt die dargestellten Neutralisierungsvorrichtung 32 zu verwenden, kann auch so vorgegangen werden, daß das Förderband 11 aus Drähten aus elektrisch leitendem Material besteht, die ihrerseits geerdet sind, so daß ein unmittelbarer Erdkontakt zu den Werkstücken besteht. Weitere Einzelheiten der Anlage sind nicht veranschaulicht.

Sie kann in üblicher Weise Entstaubungskammern für die eingebrachten Werkstücke aufweisen. Eine Entstaubung kann auch für die Abdeckbahn 25 vorgesehen sein.

**Patentansprüche**

1. Vorrichtung zur Sprühbeschichtung von Werkstücken (10) mit einem horizontal unter einer Sprühvorrichtung (4) verlaufenden Transportweg für die Werkstücke (10) und einer unter den Werkstücken (10) angeordneten, einmal verwendbaren Abdeckbahn (25) zur Aufnahme von nicht auf die Werkstücke auftreffendem Beschichtungsmaterial, insbesondere zur elektrostatischen Beschichtung mittels eines Rotationszerstäubers (5), dadurch gekennzeichnet, daß zum Transport der Werkstücke (10) ein endloses, durchbrochenes Förderband (11) vorgesehen ist und daß die Abdeckbahn (25) unter dem Förderband verläuft und eine geringere Durchschnittsgeschwindigkeit als das Förderband hat.

2. Vorrichtung nach Anspruch 1, dadurch gekennzeichnet, daß das Förderband (11) aus mehreren parallelen Drähten, Schnüren oder Fäden (12) besteht.

3. Vorrichtung nach Anspruch 1 oder 2, dadurch gekennzeichnet, daß das Förderband (11) aus isolierendem Kunststoff besteht.

4. Vorrichtung nach einem der Ansprüche 1 bis 3, dadurch gekennzeichnet, daß das Förderband (11) beim Rücklauf eine Reinigungsvorrichtung (23) durchläuft.

5. Vorrichtung nach einem der Ansprüche 1 bis 4, dadurch gekennzeichnet, daß die Abdeckbahn (25) aus leichtem Papier mit einem Gewicht von höchstens 40g/m$^2$ besteht.

6. Vorrichtung nach einem der Ansprüche 1 bis 5, dadurch gekennzeichnet, daß die Abdeckbahn (125) nur an den Rändern des Förderbandes vorgesehen ist.

7. Vorrichtung nach einem der Ansprüche 1 bis 6, dadurch gekennzeichnet, daß für die Abdeckbahn (25) ein in Intervallen arbeitender Antrieb (27) vorgesehen ist.

8. Vorrichtung nach einem der Ansprüche 1 bis 7, dadurch gekennzeichnet, daß die Betätigung des Antriebs (27) für die Abdeckbahn (25) von deren Verschmutzungsgrad abhängig ist.

9. Vorrichtung nach einem der Ansprüche 1 bis 8, dadurch gekennzeichnet, daß bei elektrostatischer Beschichtung das Förderband (11) aus elektrisch leitendem Material besteht und geerdet ist.

10. Vorrichtung nach einem der Ansprüche 1 bis 8, dadurch gekennzeichnet, daß bei elektrostatischer Beschichtung zur berührungslosen Entladung der Werkstücke (10) eine mit Luftionisation arbeitende Neutralisierungsvorrichtung (32) unterhalb der Abdeckbahn (25) angeordnet ist.

11. Vorrichtung nach einem der Ansprüche 1 bis 10, dadurch gekennzeichnet, daß die Abdeckbahn (25) für Luft, nicht aber für Beschichtungsmaterial durchlässig ist.

12. Vorrichtung nach einem der Ansprüche 1 bis 11, dadurch gekennzeichnet, daß die Abdeckbahn (25) fein gelocht ist.

13. Vorrichtung nach einem der Ansprüche 1 bis 11, dadurch gekennzeichnet, daß die Abdeckbahn (25) aus einem Vlies besteht.

14. Vorrichtung nach einem der Ansprüche 1 bis 13, dadurch gekennzeichnet, daß die Neutralisierungsvorrichtung (32) so dicht unterhalb der Abdeckbahn (25) angeordnet ist, daß diese im Ionisierungsbereich der Neutralisierungsvorrichtung liegt.

15. Vorrichtung nach einem der Ansprüche 1 bis 14, dadurch gekennzeichnet, daß die Neutralisierungsvorrichtung (32) eine Anzahl von zur Abdeckbahn (25) hin gerichteten Ionisierungs-Spitzen (34) aufweist.

16. Vorrichtung nach Anspruch 15, dadurch gekennzeichnet, daß die Ionisierungs-Spitzen (34) in mehreren Reihen angeordnet sind, die quer zur Förderrichtung nebeneinander angeordnet sind, wobei die Wirkungsbreite durch Zu- bzw. Abschalten von einzelnen Reihen einstellbar ist.

17. Vorrichtung nach einem der Ansprüche 1 bis 16, dadurch gekennzeichnet, daß der vertikale Abstand der Abdeckbahn (25) vom Förderband (11) gerade so groß ist, daß bei beladenem Förderband noch keine Berührung stattfindet.

18. Vorrichtung nach einem der Ansprüche 1 bis 17, dadurch gekennzeichnet, daß die Abdeckbahn (25) den Boden einer Kabine (1) bildet, in der die Sprühvorrichtung (4) angeordnet ist.

19. Vorrichtung nach einem der Ansprüche 1 bis 18, dadurch gekennzeichnet, daß die Kabine (1) mit Unterdruck betreibbar ist.

## Claims

1. Apparatus for the spray coating of workpieces (10) with a transport path for the workpieces (10) extending horizontally under a spraying device (4) and a non-reusable masking web (25) arranged under the workpieces (10) for receiving coating material which does not impinge on the workpieces, in particular for electrostatic coating by means of a rotary atomiser (5), characterised in that an endless, open-work conveyor belt (11) is provided for the transport of the workpieces (10) and that the masking web (25) runs under the conveyor belt and has a lower average speed than the conveyor belt.

2. Apparatus according to claim 1, characterised in that the conveyor belt (11) consists of several parallel wires, cords or threads (12).

3. Apparatus according to claim 1 or 2, characterised in that the conveyor belt (11) is made of insulating plastic.

4. Apparatus according to any of claims 1 to 3, characterised in that the conveyor belt (11) passes through a cleaning device (23) during the return.

**5.** Apparatus according to any of claims 1 to 4, characterised in that the masking web (25) is made of lightweight paper with a weight of not more than 40 g/m$^2$.

**6.** Apparatus according to any of claims 1 to 5, characterised in that the masking web (125) is provided only at the edges of the conveyor belt.

**7.** Apparatus according to any of claims 1 to 6, characterised in that an intermittently operating drive (27) is provided for the masking web (25).

**8.** Apparatus according to any of claims 1 to 7, characterised in that operation of the drive (27) for the masking web (25) is dependent on the degree of soiling thereof.

**9.** Apparatus according to any of claims 1 to 8, characterised in that in case of electrostatic coating, the conveyor belt (11) is made of electrically conducting material and earthed.

**10.** Apparatus according to any of claims 1 to 8, characterised in that in case of electrostatic coating for discharge of the workpieces (10) without contact, a neutralising device (32) which operates by air ionisation is arranged beneath the masking web (25).

**11.** Apparatus according to any of claims 1 to 10, characterised in that the masking web (25) is permeable to air, but not to coating material.

**12.** Apparatus according to any of claims 1 to 11, characterised in that the masking web (25) is finely perforated.

**13.** Apparatus according to any of claims 1 to 11, characterised in that the masking web (25) consists of a fleece.

**14.** Apparatus according to any of claims 1 to 13, characterised in that the neutralising device (32) is arranged so close underneath the masking web (25) that the latter is located within the ionising range of the neutralising device.

**15.** Apparatus according to any of claims 1 to 14, characterised in that the neutralising device (32) has a number of ionising points (34) directed towards the masking web (25).

**16.** Apparatus according to claim 15, characterised in that the ionising points (34) are arranged in several rows which are arranged adjacent to each other transversely to the direction of transport, wherein the working width is adjustable by switching individual rows on and off.

**17.** Apparatus according to any of claims 1 to 16, characterised in that the vertical distance of the masking web (25) from the conveyor belt (11) is so great that when the conveyor belt is loaded, there is still no contact.

**18.** Apparatus according to any of claims 1 to 17, characterised in that the masking web (25) forms the floor of a cabin (1) in which the spraying device (4) is arranged.

**19.** Apparatus according to any of claims 1 to 18, characterised in that the cabin (1) can be operated at partial pressure.

**Revendications**

**1.** Dispositif de revêtement par pulvérisation de pièces (10), comprenant une bande transporteuse passant horizontalement au-dessous d'un dispositif de pulvérisation (4) et une bande de recouvrement (25) disposée au-dessous des pièces (10) et utilisable une seule fois, en vue de recevoir le produit de revêtement qui ne parvient pas sur les pièces, notamment pour un revêtement électrostatique au moyen d'un pulvérisateur rotatif (5), caractérisé en ce que l'on prévoit pour le transport des pièces (10) une bande transporteuse (11) sans fin et ajourée, et en ce que la bande de recouvrement (25) passe au-dessous de la bande transporteuse et est animée d'une vitesse moyenne plus lente que celle de la bande transporteuse.

**2.** Dispositif selon la revendication 1, caractérisé en ce que la bande transporteuse (11) est constituée par plusieurs fils métalliques, cordons ou fils (12) qui sont parallèles.

**3.** Dispositif selon la revendication 2, caractérisé en ce que la bande transporteuse (11) est réalisée en une matière plastique isolante.

**4.** Dispositif selon l'une quelconque des revendications 1 à 3, caractérisé en ce que la bande transporteuse (11) traverse un dispositif de nettoyage (23) sur son parcours de retour.

**5.** Dispositif selon l'une quelconque des revendications 1 à 4, caractérisé en ce que la bande de recouvrement (25) est constituée en un papier léger dont le poids est au maximum de 40 g/m$^2$.

6. Dispositif selon l'une quelconque des revendications 1 à 5, caractérisé en ce que la bande de recouvrement (125) n'est prévue que sur les bords de la bande transporteuse.

7. Dispositif selon l'une quelconque des revendications 1 à 6, caractérisé en ce qu'il est prévu pour la bande de recouvrement (25) un mécanisme d'entraînement (27) fonctionnant de façon discontinue.

8. Dispositif selon l'une quelconque des revendications 1 à 7, caractérisé en ce que l'actionnement du mécanisme (27) destiné à la bande de recouvrement (25) est dépendant de son degré de salissure.

9. Dispositif selon l'une quelconque des revendications 1 à 8, caractérisé en ce que lorsqu'il s'agit d'un revêtement électrostatique, la bande transporteuse (11) est constituée en un matériau électriquement conducteur et mis à la terre.

10. Dispositif selon l'une quelconque des revendications 1 à 8, caractérisé en ce que, lorsqu'il s'agit d'un revêtement électrostatique et pour une décharge sans contact des pièces (10), on dispose au-dessous de la bande de recouvrement (25) un dispositif de neutralisation (32) fonctionnant par ionisation de l'air.

11. Dispositif selon l'une quelconque des revendications 1 à 10, caractérisé en ce que la bande de recouvrement (25) laisse passer l'air mais ne laisse pas passer le produit de revêtement.

12. Dispositif selon l'une quelconque des revendications 1 à 11, caractérisé en ce que la bande de recouvrement (25) est finement perforée.

13. Dispositif selon l'une quelconque des revendications 1 à 11, caractérisé en ce que la bande de recouvrement (25) est constituée par un feutre.

14. Dispositif selon l'une quelconque des revendications 1 à 13, caractérisé en ce que le dispositif de neutralisation (32) est disposé étroitement au-dessous de la bande de recouvrement (25) de manière que cette dernière soit située dans la zone d'ionisation du dispositif de neutralisation.

15. Dispositif selon l'une quelconque des revendications 1 à 14, caractérisé en ce que le dispositif de neutralisation (32) comprend un certain nombre de pointes d'ionisation (34) dirigées vers la bande de recouvrement (25).

16. Dispositif selon la revendication 15, caractérisé en ce que les pointes d'ionisation (34) sont disposées sur plusieurs rangées qui sont disposées les unes contre les autres et transversalement à la direction du transport, la largeur d'effet pouvant être réglée par activation ou coupure de rangées individuelles.

17. Dispositif selon l'une quelconque des revendications 1 à 16, caractérisé en ce que la distance verticale entre la bande de recouvrement (25) et la bande transporteuse (11) est juste assez importante pour qu'aucun contact n'ait lieu quand la bande transporteuse est chargée.

18. Dispositif selon l'une quelconque des revendications 1 à 17, caractérisé en ce que la bande de recouvrement (25) forme le sol d'une cabine (1) dans laquelle est monté le dispositif de pulvérisation (4).

19. Dispositif selon l'une quelconque des revendications 1 à 18, caractérisé en ce que la cabine (1) peut être utilisée en dépression.

Fig.1

EP 0 260 539 B1

Fig.2

Fig.3

Fig.4

Fig.5